# EUROPÄISCHE PATENTANMELDUNG

(11) **EP 3 624 573 A1**
(43) Veröffentlichungstag der Anmeldung: **18.03.2020**
(21) Anmeldenummer: 19189897.2
(22) Anmeldetag: 02.08.2019
(51) Int. Cl.: H05K 5/00

(54) **STEUERGERÄTEEINHEIT UND VERFAHREN ZUM HERSTELLEN EINER STEUERGERÄTEEINHEIT**

(30) Priorität: 14.09.2018 DE 102018215711
(71) Anmelder: Robert Bosch GmbH, 70442 Stuttgart (DE)
(72) Erfinder: Heyna, Oliver, 74321 Bietigheim-Bissingen (DE); Neumeister, Jochen, 70469 Stuttgart (DE)

(57) **Zusammenfassung**

Es wird eine Steuergeräteeinheit (10), insbesondere für ein Kraftfahrzeug, vorgeschlagen, wobei die Steuergeräteeinheit (10) folgendes umfasst: einen Zwischenträger (30) mit einer Vielzahl von auf einer Vorderseite des Zwischenträgers (30) angeordneten elektrischen Bauelementen (11-14), und einen teilweise auf dem Zwischenträger (30) angeordneten Deckel (50), wobei der Deckel (50) die elektrischen Bauelemente (11-14) in einem Hohlraum (55) zwischen dem Deckel (50) und dem Zwischenträger (30) einschließt, dadurch gekennzeichnet, dass ein Vergussmaterial (57) in einem Stück einen Rand des Deckels (50), insbesondere den Deckel (50) vollständig, und den Zwischenträger (30) zumindest teilweise bedeckt, wobei das Vergussmaterial (57) den Hohlraum (55) flüssigkeitsdicht abschließt und den Deckel (50) an dem Zwischenträger (30) befestigt.

## Beschreibung

### Gebiet der Erfindung

Die Erfindung betrifft eine Steuergeräteeinheit und ein Verfahren zum Herstellen einer Steuergeräteeinheit.

### Stand der Technik

Steuergeräteeinheiten, insbesondere Steuergeräteinheiten für Kraftfahrzeuge, z.B. für die Getriebesteuerung werden oftmals in einer (Getriebe-)Ölumgebung angeordnet bzw. betrieben. Hierzu müssen elektrische Bauelemente auf einem Schaltungsträger und Verbindungen zwischen den elektrischen Bauelementen und dem Schaltungsträger vor dem Öl der (Getriebe-)Ölumgebung geschützt werden.

Bekannte Maßnahmen hierfür sind:
1. Die Steuergeräteeinheit weist ein flüssigkeitsdichtes (Edel-)Stahlgehäuse mit Durchkontaktierungen aus Glas zum elektrischen Verbinden der Steuergeräteeinheit mit weiteren Elementen auf. Nachteilig hieran ist, dass das Herstellen des (Edel-)Stahlgehäuses technisch aufwändig ist. Zudem ist das Herstellen der Steuergeräteeinheit aufgrund des Materials des Gehäuses teuer.
2. Ein Vergussmaterial wird auf den Schaltungsträger, auf dem die elektrischen Bauelemente angeordnet sind, aufgebracht und ausgehärtet. Das Vergussmaterial bedeckt die elektrischen Bauelemente und die Verbindungen zwischen den elektrischen Bauelementen und dem Schaltungsträger. Nachteilig hieran ist, dass das Vergussmaterial in direktem Kontakt mit den elektrischen Bauelementen und den Verbindungen zwischen den elektrischen Bauelementen und dem Schaltungsträger steht. Dies kann zu ungewollten chemischen Reaktionen führen. Zudem ist das Herstellen technisch aufwändig.
3. Ein Kunststoffdeckel wird auf den Schaltungsträger aufgebracht, wodurch die elektrischen Bauelemente der Steuergeräteeinheit in einem Hohlraum zwischen dem Kunststoffdeckel und dem Schaltungsträger eingeschlossen sind. Zwischen dem Kunststoffdeckel und dem Schaltungsträger ist eine Dichtung zum flüssigkeitsdichten Abdichten des Hohlraums gegenüber der Umgebung angeordnet. Nachteilig hieran ist, dass das Herstellen technisch aufwändig ist. Zudem kann die Dichtung unter ungünstigen Umständen undicht werden, so dass Flüssigkeit in den Hohlraum gelangt.

### Offenbarung der Erfindung

Vor diesem Hintergrund werden mit dem hier vorgestellten Ansatz eine Steuergeräteeinheit bzw. ein Verfahren zum Herstellen einer Steuergeräteeinheit gemäß den unabhängigen Ansprüchen vorgestellt. Vorteilhafte Weiterbildungen und Verbesserungen des hier vorgestellten Ansatzes ergeben sich aus der Beschreibung und sind in den abhängigen Ansprüchen beschrieben.

### Vorteile der Erfindung

Ausführungsformen der vorliegenden Erfindung können in vorteilhafter Weise ermöglichen, Bauelemente einer Steuergeräteeinheit technisch einfach flüssigkeitsdicht gegenüber der Umgebung abzudichten.

Gemäß einem ersten Aspekt der Erfindung wird eine Steuergeräteeinheit, insbesondere für ein Kraftfahrzeug, vorgeschlagen, wobei die Steuergeräteeinheit folgendes umfasst: einen Zwischenträger mit einer Vielzahl von auf einer Vorderseite des Zwischenträgers angeordneten elektrischen Bauelementen, und einen teilweise auf dem Zwischenträger angeordneten Deckel, wobei der Deckel die elektrischen Bauelemente in einem Hohlraum zwischen dem Deckel und dem Zwischenträger einschließt, dadurch gekennzeichnet, dass ein Vergussmaterial in einem Stück einen Rand des Deckels, insbesondere den Deckel vollständig, und den Zwischenträger zumindest teilweise bedeckt, wobei das Vergussmaterial den Hohlraum flüssigkeitsdicht abschließt und den Deckel an dem Zwischenträger befestigt.

Ein Vorteil hiervon ist, dass der Hohlraum typischerweise besonders zuverlässig von der Umgebung flüssigkeitsdicht abgedichtet ist. Insbesondere wird durch die flächige Abdichtung im Allgemeinen verhindert, dass ein Spalt oder ähnliches entstehen kann, durch welchen Öl oder Fremdstoffe in den Hohlraum eindringen können. Zudem kann die flüssigkeitsdichte Abdichtung des Hohlraums gegenüber der Umgebung in der Regel technisch besonders einfach hergestellt werden. Darüber hinaus ist üblicherweise die Herstellung kostengünstig.

Gemäß einem zweiten Aspekt der Erfindung wird ein Verfahren zum Herstellen einer Steuergeräteeinheit, insbesondere für ein Kraftfahrzeug, vorgeschlagen, wobei das Verfahren folgende Schritte umfasst: Bereitstellen eines Zwischenträgers mit einer Vielzahl von auf einer Vorderseite des Zwischenträgers angeordneten elektrischen Bauelementen; Anordnen eines Deckels teilweise auf dem Zwischenträger derart, dass der Deckel die elektrischen Bauelemente in einem Hohlraum zwischen dem Deckel und dem Zwischenträger einschließt; Aufbringen eines Vergussmaterials auf den Deckel und den Zwischenträger derart, dass das Vergussmaterial in einem Stück einen Rand des Deckels, insbesondere den Deckel vollständig, und den Zwischenträger zumindest teilweise bedeckt; und Aushärten des Vergussmaterials.

Ein Vorteil hiervon ist, dass der Hohlraum typischerweise besonders zuverlässig von der Umgebung flüssigkeitsdicht abgedichtet wird. Insbesondere wird durch die flächige Abdichtung im Allgemeinen verhindert, dass ein Spalt oder ähnliches entstehen kann, durch welchen Öl oder Fremdstoffe in den Hohlraum eindringen können. Zudem wird die flüssigkeitsdichte Abdichtung des Hohlraums gegenüber der Umgebung in der Regel technisch besonders einfach hergestellt. Darüber hinaus ist das Verfahren üblicherweise besonders kostengünstig ausführbar.

Ideen zu Ausführungsformen der vorliegenden Erfindung können unter anderem als auf den nachfolgend beschriebenen Gedanken und Erkenntnissen beruhend angesehen werden.

Die Erfindung basiert insbesondere auf der Idee, einen Deckel über die Bauelemente zu stülpen und anschließend den Deckel mit einem einstückigen Vergussmaterial zu bedecken und den Deckel hierdurch mit dem Element, auf dem der Deckel liegt, zu verbinden. Somit ist der Hohlraum unter dem Deckel technisch besonders sicher gegenüber der Umgebung flüssigkeitsdicht abgedichtet.

Gemäß einer Ausführungsform der Steuergeräteeinheit weist die Steuergeräteeinheit ferner einen auf dem Zwischenträger angeordneten Schaltungsträger auf, wobei die elektrischen Bauelemente auf dem Schaltungsträger angeordnet sind. Hierdurch sind die Bauelemente im Allgemeinen technisch einfach miteinander verbunden bzw. verschaltet.

Gemäß einer Ausführungsform der Steuergeräteeinheit umfasst die Steuergeräteeinheit ferner einen Hauptträger, wobei der Zwischenträger mit dem Hauptträger elektrisch verbunden ist, wobei das Vergussmaterial in einem Stück auf dem Deckel, dem Zwischenträger und teilweise auf dem Hauptträger angeordnet ist. Vorteilhaft hieran ist, dass typischerweise technisch besonders einfach eine elektrische Verbindung mit weiteren Elementen hergestellt werden kann.

Gemäß einer Ausführungsform der Steuergeräteeinheit weist der Deckel bereichsweise eine flache Außenoberfläche auf. Ein Vorteil hiervon ist, dass der Deckel in der Regel mittels eines Sauggreifers ergriffen und bei der Herstellung technisch einfach bewegt bzw. positioniert werden kann. Somit ist der Herstellungsprozess im Allgemeinen technisch besonders einfach. Zudem kann das Vergussmaterial beim Herstellen typischerweise technisch besonders einfach auf den Deckel aufgebracht werden.

Gemäß einer Ausführungsform der Steuergeräteeinheit berührt der Deckel die Bauelemente nicht. Vorteilhaft hieran ist, dass in der Regel keine unerwünschten chemischen Reaktionen zwischen dem Deckel und dem Bauelementen stattfinden können. Somit ist die Steuergeräteeinheit im Allgemeinen besonders langlebig.

Gemäß einer Ausführungsform des Verfahrens wird das Vergussmaterial derart auf den Deckel, den Zwischenträger und einen Hauptträger aufgebracht, dass das Vergussmaterial in einem Stück ist, wobei der Hauptträger elektrisch mit dem Zwischenträger verbunden ist. Vorteilhaft hieran ist, dass typischerweise technisch besonders einfach eine elektrische Verbindung mit weiteren Elementen hergestellt werden kann.

Gemäß einer Ausführungsform des Verfahrens ist der Hauptträger mit dem Zwischenträger verlötet und eine der Vorderseite gegenüberliegende Rückseite des Zwischenträgers ist teilweise nicht flüssigkeitsdicht gegenüber der Umgebung abgedichtet. Vorteilhaft hieran ist, dass der Zwischenträger im Allgemeinen vollständig von dem Vergussmaterial bedeckt werden kann. Hierdurch kann typischerweise eine noch zuverlässigere flüssigkeitsdichte Abdichtung des Hohlraums gegenüber der Umgebung erreicht werden.

Gemäß einer Ausführungsform des Verfahrens weist der Deckel bereichsweise eine flache Außenoberfläche zum Greifen des Deckels mit einem Sauggreifer auf und der Deckel wird mittels Sauggreifer auf dem Zwischenträger angeordnet. Ein Vorteil hiervon ist, dass der Deckel in der Regel technisch einfach ergriffen und technisch einfach bewegt bzw. positioniert werden kann. Somit ist das Verfahren im Allgemeinen technisch besonders einfach. Zudem kann hierbei das Vergussmaterial beim Herstellen typischerweise technisch besonders einfach auf den Deckel aufgebracht werden. Die Kontaktierung zwischen dem Deckel und dem Zwischenträger kann insbesondere mittels eines bekannten Reflowprozesses durchgeführt werden.

Gemäß einer Ausführungsform des Verfahrens wird der Deckel derart auf dem Zwischenträger angeordnet, dass der Deckel die Bauelemente nicht berührt. Vorteilhaft hieran ist, dass in der Regel keine unerwünschten chemischen Reaktionen zwischen dem Deckel und dem Bauelementen stattfinden können. Somit ist die durch dieses Verfahren hergestellte Steuergeräteeinheit im Allgemeinen besonders langlebig.

Es wird darauf hingewiesen, dass einige der möglichen Merkmale und Vorteile der Erfindung hierin mit Bezug auf unterschiedliche Ausführungsformen der Steuergeräteeinheit bzw. des Verfahrens zum Herstellen einer Steuergeräteeinheit beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine Querschnittsansicht einer ersten Ausführungsform der erfindungsgemäßen Steuergeräteeinheit; und
- Fig. 2 zeigt: eine Querschnittsansicht einer zweiten Ausführungsform der erfindungsgemäßen Steuergeräteeinheit.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

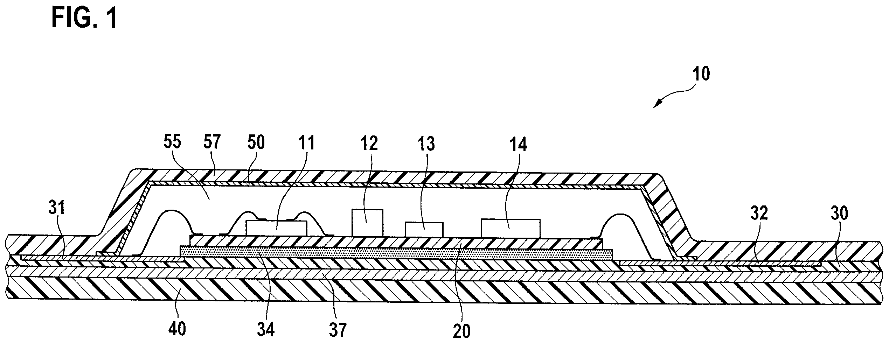

Fig. 1 zeigt eine Querschnittsansicht einer ersten Ausführungsform der erfindungsgemäßen Steuergeräteeinheit 10.

Die Steuergeräteeinheit 10 umfasst einen Schaltungsträger 20, auf dem eine Vielzahl von elektrischen bzw. elektronischen Bauelementen 11-14 angeordnet ist. Die Bauelemente 11-14 sind teilweise per Drahtbonden mit dem Schaltungsträger 20 elektrisch verbunden. Der Schaltungsträger 20 ist mittels einer Klebeschicht 34 flächig mit einem Zwischenträger 30 verbunden. Der Schaltungsträger 20 ist mittels Drahtbonden mit dem Zwischenträger 30 elektrisch verbunden. Der Zwischenträger 30 verläuft parallel zu dem Schaltungsträger 20. Anstelle von Drahtbonden ist auch eine Lötverbindung und/oder eine Schweißverbindung vorstellbar.

Der Schaltungsträger 20 kann eine Leiterplatte (printed circuit board, PCB) und/oder eine Niedertemperatur-Einbrand-Keramik (Low Temperature Cofired Ceramics, LTCC) umfassen oder daraus bestehen.

Der Zwischenträger 30 weist mehrere Leitbahnen 31, 32 zum elektrischen Verbinden auf, wobei die Leitbahnen 31, 32 elektrisch mit dem Schaltungsträger 20 und somit mit den elektrischen bzw. elektronischen Bauelementen 11-14 verbunden sind. Die Leitbahnen 31, 32 können mehrschichtig ausgebildet sein.

Der Zwischenträger 30 kann z.B. eine Leiterplatte (printed circuit board, PCB), ein spritzgegossener Schaltungsträger 20 (molded interconnect devices, MID), ein Stanzgitter, eine starr-flexible Leiterplatte (flexible printed circuit, FPC) und/oder eine Flexfolie (FCB) umfassen oder daraus bestehen. Auf dem Zwischenträger 30 können auch weitere Bauelemente 11-14 sein, die nicht von dem Deckel 50 bedeckt bzw. nicht in dem Hohlraum 55 angeordnet sind bzw. werden. Der Zwischenträger 30 kann z.B. mittels einer Leiterplatte (printed circuit board, PCB), einem spritzgegossenen Schaltungsträger 20 (molded interconnect devices, MID), einem Stanzgitter und/oder einer Flexfolie (FCB) mit weiteren Elementen elektrisch verbunden werden bzw. sein. Der Zwischenträger 30 kann z.B. mit einer größeren bzw. weiteren Leiterplatte, elektrischen Lasten, Sensoren und/oder mit einem Stecker mit dem Bordnetz des Fahrzeugs verbunden sein.

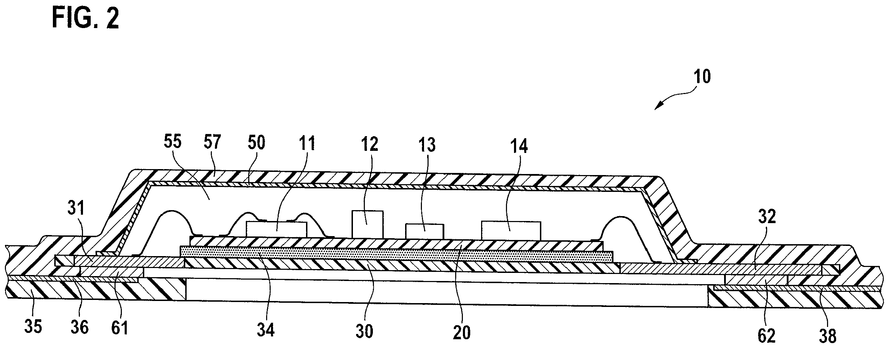

Auf der dem Schaltungsträger 20 abgewandten Seite des Zwischenträgers 30 ist eine Trägerplatte 40 angeordnet, die für eine mechanische Stabilität der Steuergeräteeinheit 10 sorgt. Ein Hauptträger 35 wie in Fig. 2 ist bei der ersten Ausführungsform in Fig. 1 nicht vorhanden. Zwischen dem Zwischenträger 30 und der Trägerplatte 40 ist eine Klebstoffschicht 37 zum Verbinden des Zwischenträgers 30 mit der Trägerplatte und/oder eine Isolationsschicht angeordnet.

Die Steuergeräteeinheit 10 weist einen Deckel 50 auf. Der Deckel 50 ist auf dem Zwischenträger 30 angeordnet. Der Deckel 50 weist im Wesentlichen eine Hutform auf, wobei eine Oberseite des Deckels 50 plan ausgebildet und parallel zu dem Zwischenträger 30 verläuft. Der Deckel 50 bildet einen Hohlraum 55 zwischen dem Deckel 50 und dem Zwischenträger 30. In diesem Hohlraum 55 sind die elektrischen Bauelemente 11-14 und der Schaltungsträger 20 angeordnet. Die Leitbahnen 31, 32 des Zwischenträgers 30 führen von dem Hohlraum 55 aus in die Umgebung.

Der Deckel 50 kann ein Kunststoffdeckel sein. Vorstellbar ist auch, dass der Deckel 50 Füllstoffe, z.B. Metall und/oder Metalllegierung zum elektromagnetischen Abschirmen aufweist. Der Deckel 50 berührt die elektrischen Bauelemente 11-14 im Regelfall nicht. Der Deckel 50 berührt im Regelfall die Bonddrähte nicht. Der Deckel 50 ist formstabil ausgebildet. Der Deckel 50 schließt den Hohlraum 55 nach außen hin ab. Die elektronischen Bauelemente 11-14 sind somit weder in Kontakt mit dem Vergussmaterial 57 noch mit dem Deckel 50. Somit können keine unerwünschten chemischen Reaktionen mit dem Vergussmaterial 57 und/oder mit dem Deckel 50 stattfinden.

Auf der Außenseite des Deckels 50, d.h. der dem Hohlraum 55 abgewandten Seite des Deckels 50, ist ein Vergussmaterial 57 angeordnet. Das Vergussmaterial 57 bedeckt den Deckel 50 vollständig auf seiner Außenseite oder bedeckt zumindest den Bereich der Berandung bzw. den Rand des Deckels 50 komplett bzw. vollständig. Zudem bedeckt das Vergussmaterial 57 zumindest einen Teil des Zwischenträgers 30. Hierdurch wird der Deckel 50 fest mit dem Zwischenträger 30 verbunden bzw. daran befestigt. Das Vergussmaterial 57 sorgt für eine flüssigkeitsdichte Abdichtung des Hohlraums 55 in dem Deckel 50 gegenüber der Umgebung. Das Vergussmaterial 57 haftet an dem Zwischenträger 30.

Das Vergussmaterial 57 wird üblicherweise in flüssiger bzw. zähflüssiger Form aufgebracht und anschließend ausgehärtet. Die Kontur des Vergussmaterials 57 folgt der Kontur des Deckels 50 bzw. des Zwischenträgers 30. Das Vergussmaterial 57 kann auf dem Deckel 50 eine geringere Dicke als auf dem Zwischenträger 30 aufweisen. Vorstellbar ist jedoch auch, dass das Vergussmaterial 57 überall dieselbe Dicke aufweist. Das Vergussmaterial 57 wird nach dem Aufbringen ausgehärtet, z.B. durch UV-Licht und/oder durch Wärme.

Das Vergussmaterial 57 ist einstückig bzw. zusammenhängend ausgebildet. Dies bedeutet, dass der Teil des Vergussmaterials 57, der sich auf dem Deckel 50 befindet, ohne Unterbrechung bzw. Lücke in den Teil des Vergussmaterials 57 übergeht, der auf dem Zwischenträger 30 angeordnet ist.

Wenn die Steuergeräteeinheit 10 in einer Ölumgebung z.B. in einem Getriebe verwendet wird, gelangt trotzdem kein Öl an den Deckel 50, da dieser vollständig vom Vergussmaterial 57 bedeckt ist. Der Deckel 50 kann somit aus einem Material bestehen, das nicht ölbeständig ist. Der Deckel 50 kann sogar öldurchlässig ausgebildet sein.

Der Hohlraum 55 kann mit einem Gas und/oder Gasgemisch gefüllt sein. Auch möglich ist, dass der Hohlraum 55 mit einer Flüssigkeit (z.B. Öl) und/oder einem Gel gefüllt ist. Grundsätzlich vorstellbar ist auch, dass der Hohlraum 55 mit einem Feststoff gefüllt ist.

Im Regelfall ist der Hohlraum 55 nicht nur flüssigkeitsdicht gegenüber der Umgebung abgedichtet, sondern sogar gasdicht gegenüber der Umgebung abgedichtet.

Es wird kein Dichtring oder ähnliches benötigt. Es ist keine Dichtkante oder Spalte vorhanden, an der die Dichtung undicht werden kann. Die Abdichtung ist (groß)flächig ausgebildet. Zudem kann der Schaltungsträger 20 maschinell bestückt werden, so dass keine Sonderfertigungsprozesse notwendig sind.

Fig. 2 zeigt eine Querschnittsansicht einer zweiten Ausführungsform der erfindungsgemäßen Steuergeräteeinheit 10.

Die zweite Ausführungsform unterscheidet sich hauptsächlich von der ersten Ausführungsform dadurch, dass der Zwischenträger 30 mittels elektrischer Verbindungselemente 61, 62 mit Leitbahnen 36, 38 des Hauptträgers 35 elektrisch mit dem Hauptträger 35 verbunden ist. Die elektrischen Verbindungselemente 61, 62 können z.B. durch Löten hergestellt werden. Der Hauptträger 35 weist eine Aussparung auf, so dass die dem Hohlraum 55 abgewandte Rückseite des Zwischenträgers 30 teilweise bzw. großflächig freiliegt. Das Vergussmaterial 57 bedeckt den Deckel 50 vollständig, einen Teil des Zwischenträgers 30 und einen Teil des Hauptträgers 35 in einem Stück bzw. zusammenhängend.

Die elektrischen Bauelemente können z.B. Transistoren, Widerstände, Induktivitäten, Kapazitäten und/oder integrierte Schaltungen umfassen.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Steuergeräteeinheit (10), insbesondere für ein Kraftfahrzeug, wobei die Steuergeräteeinheit (10) folgendes umfasst:
einen Zwischenträger (30) mit einer Vielzahl von auf einer Vorderseite des Zwischenträgers (30) angeordneten elektrischen Bauelementen (11-14), und
einen teilweise auf dem Zwischenträger (30) angeordneten Deckel (50),
wobei der Deckel (50) die elektrischen Bauelemente (11-14) in einem Hohlraum (55) zwischen dem Deckel (50) und dem Zwischenträger (30) einschließt,
**dadurch gekennzeichnet, dass**
ein Vergussmaterial (57) in einem Stück einen Rand des Deckels (50), insbesondere den Deckel (50) vollständig, und den Zwischenträger (30) zumindest teilweise bedeckt,
wobei das Vergussmaterial (57) den Hohlraum (55) flüssigkeitsdicht abschließt und den Deckel (50) an dem Zwischenträger (30) befestigt.

2. Steuergeräteeinheit (10) nach Anspruch 1, wobei
die Steuergeräteeinheit (10) ferner einen auf dem Zwischenträger (30) angeordneten Schaltungsträger (20) aufweist, wobei die elektrischen Bauelemente (11-14) auf dem Schaltungsträger (20) angeordnet sind.

3. Steuergeräteeinheit (10) nach Anspruch 1 oder 2,
wobei die Steuergeräteeinheit (10) ferner einen Hauptträger (35) umfasst, wobei der Zwischenträger (30) mit dem Hauptträger (35) elektrisch verbunden ist, wobei das Vergussmaterial (57) in einem Stück auf dem Deckel (50), dem Zwischenträger (30) und teilweise auf dem Hauptträger (35) angeordnet ist.

4. Steuergeräteeinheit (10) nach einem der vorhergehenden Ansprüche, wobei der Deckel (50) bereichsweise eine flache Außenoberfläche aufweist.

5. Steuergeräteeinheit (10) nach einem der vorhergehenden Ansprüche, wobei der Deckel (50) die Bauelemente (11-14) nicht berührt.

6. Verfahren zum Herstellen einer Steuergeräteeinheit (10), insbesondere für ein Kraftfahrzeug,
wobei das Verfahren folgende Schritte umfasst:
Bereitstellen eines Zwischenträgers (30) mit einer Vielzahl von auf einer Vorderseite des Zwischenträgers (30) angeordneten elektrischen Bauelementen (11-14);
Anordnen eines Deckels (50) teilweise auf dem Zwischenträger (30) derart, dass der Deckel (50) die elektrischen Bauelemente (11-14) in einem Hohlraum (55) zwischen dem Deckel (50) und dem Zwischenträger (30) einschließt;
Aufbringen eines Vergussmaterials (57) auf den Deckel (50) und den Zwischenträger (30) derart, dass das Vergussmaterial (57) in einem Stück einen Rand des Deckels (50), insbesondere den Deckel (50) vollständig, und den Zwischenträger (30) zumindest teilweise bedeckt; und
Aushärten des Vergussmaterials (57).

7. Verfahren nach Anspruch 6, wobei
das Vergussmaterial (57) derart auf den Deckel (50), den Zwischenträger (30) und einen Hauptträger (35) aufgebracht wird, dass das Vergussmaterial (57) in einem Stück ist, wobei der Hauptträger (35) elektrisch mit dem Zwischenträger (30) verbunden ist.

8. Verfahren nach Anspruch 7, wobei
der Hauptträger (35) mit dem Zwischenträger (30) verlötet ist und eine der Vorderseite gegenüberliegende Rückseite des Zwischenträgers (30) teilweise nicht flüssigkeitsdicht gegenüber der Umgebung abgedichtet ist.

9. Verfahren nach einem der Ansprüche 6-8, wobei
der Deckel (50) bereichsweise eine flache Außenoberfläche zum Greifen des Deckels (50) mit einem Sauggreifer aufweist und der Deckel (50) mittels Sauggreifer auf dem Zwischenträger (30) angeordnet wird.

10. Verfahren nach einem der Ansprüche 6-9, wobei
der Deckel (50) derart auf dem Zwischenträger (30) angeordnet wird, dass der Deckel (50) die Bauelemente (11-14) nicht berührt.
